# EUROPÄISCHE PATENTSCHRIFT

(11) **EP 1 654 918 B1**
(45) Veröffentlichungstag und Bekanntmachung des Hinweises auf die Patenterteilung: **14.11.2007**
(21) Anmeldenummer: 04764049.5
(22) Anmeldetag: 12.08.2004
(51) Int. Cl.: H05K 9/00, H01Q 17/00

(54) **REFLEXIONSSCHICHT**
REFLECTIVE LAYER
COUCHE REFLECHISSANTE

(30) Priorität: 14.08.2003 DE 10337792; 23.12.2003 DE 10361484
(43) Veröffentlichungstag der Anmeldung: 10.05.2006
(73) Patentinhaber: EWALD DÖRKEN AG, 58313 Herdecke (DE)
(72) Erfinder: SCHWAAB, Gilles, 44137 Dortmund (DE); SCHRÖER, Jörn, 58313 Herdecke (DE); LUNAU, Björn, 58300 Wetter (DE)
(74) Vertreter: Wenzel & Kalkoff
(86) Internationale Anmeldenummer: PCT/EP2004/009046
(87) Internationale Veröffentlichungsnummer: WO 2005/018297

(56) Entgegenhaltungen:
- EP-A- 0 742 095
- EP-A- 0 795 927
- DE-A1- 2 842 519
- DE-A1- 3 300 158
- DE-A1- 10 334 714
- DE-A1- 19 747 622

## Beschreibung

Die Erfindung betrifft eine Reflexionsschicht zur Reflexion elektromagnetischer Strahlung und ein Verfahren zum Dämpfen elektromagnetischer Strahlung.

Die Abschirmung von Wohn- und Arbeitsräumen sowie von Geräten gegen unerwünschte elektromagnetische Strahlung gewinnt zunehmend an Bedeutung. Zunächst wurden, insbesondere zur Abschirmung von Innenräumen, Spezialprodukte entwickelt, Netze oder Vliese, aus Metall, insbesondere Kupfer oder aus Kunststoffen, in die Metallfasern eingewirkt sind oder die mit Metall, insbesondere Aluminium bedampft sind. Beispiele sind hier Sisalex 514 von Fa. Ampack, ein Verbund aus Kraftpapieren mit eingelegtem Glasfasernetz und Aluminium-Kaschierung, die Schutzplatte "La Vita" von Knauf oder das Gewebe "Cuprotect special" von Fa. Kessel. Gewebe bieten die Firma Biologa ("Picasso") und die Firma Genitex ("Genitnet 36") Die abschirmende Wirkung ist durchaus zufriedenstellend, allerdings leisten diese Produkte nur diese eine Funktion. Naturgemäß sind diese zur Anwendung in Innenräumen gedachten Produkte nicht wasserdicht oder witterungsbeständig.

Für den Bereich der Fassaden- und Dacharbeiten sind ebenfalls Produkte entwickelt worden, die elektromagnetische Strahlung abschirmen sollen. Hier sind vor allem die Produkte "Profilwelle und Sidings" der Fa. Prefa (Aluminium-Fassadenelemente), das "Sto-Abschirmvlies" der Firma AES (Armierungsgewebe für dünnschichtigen Mörtel), "XUND-E" eine Schutzplatte aus Naturgips mit dünner Kohlenstoff-Auflage der Firma Baufritz, "PIR-E-Protect", eine Dämmplatte mit beidseitiger Deckschicht aus Aluminium der Firma Bauder und eine "Delta-Reflex", eine aluminiumbeschichtete Dampfsperre der Anmelderin zu nennen. Diese Produkte sind zwar jeweils schon für zwei Anwendungszwecke geeignet (z. B. Isolierung und Abschirmung oder Fassadengestaltung und Abschirmung). Sie sind aber entweder nicht wasserdicht oder aber -wenn wasserdichtnicht wasserdampfdurchlässig.

Das Produkt "TOP-E-Protect" der Fa. Bauder, eine bituminierter Verbundbahn, bei der zwischen Bitumenschicht und Vlies eine Metallbedampfung aufgetragen wurde, ist wasserdicht und wasserdampfdurchlässig.

Ist eine aufgedampfte Schicht mit einer witterungsbeständigen Kaschierung -z. B. einer Bituminierung- versehen, kann die Dampfsperre -wenn überhaupt- nur mit unverhältnismäßigem Aufwand mit einem Potentialausgleich versehen werden. Die aufgedampfte Metallschicht weist eine sehr begrenzte, in der Praxis meist nicht ausreichende Witterungsbeständigkeit auf. Dies ist darauf zurückzuführen, dass üblicherweise aufgedampfte Metallschichten der preiswerten und gängigen Art verwendet werden, die empfindlich gegen flüssiges Wasser sind, insbesondere wenn der Einfluss von Luftsauerstoff hinzutritt. Die Schichten werden leicht abgespült und korrodieren, so dass die Leitfähigkeit dieser Reflektionsschicht nicht mehr gegeben ist.

Da auch die schon sehr vielseitige TOP-E-Protect-Unterspannbahn von Fa. Bauder zwar vielseitigen Anforderungen gerecht wird, aber neben der fehlenden Witterungsbeständigkeit auch nicht zum Anschluss eines Potentialausgleichs geeignet ist, ist die Dämpfung der elektromagnetischen Strahlung nur sehr unvollständig, weil die Schutzbahn selbst einen Teil der Strahlung wieder in den abzuschirmenden Raum ausstrahlt. Besonders deutlich wir die unerwünschte Wirkung fehlender Erdung, wenn man sich verdeutlicht, dass solche Reflexionsschichten Felder naher stromführender Leitungen weiterleiten.

Es besteht daher Bedarf an einer universell einsetzbaren Reflexionsschicht, die elektromagnetische Strahlung reflektiert, und die gleichzeitig wasserdicht und wasserdampfdurchlässig sowie witterungsbeständig ist und an die ein Potentialausgleich angelegt werden kann.

Es ist die Aufgabe der Erfindung, eine derartige Reflexionsschicht bereitzustellen.

Gelöst wird diese Aufgabe durch eine Reflexionsschicht zur Dämpfung elektromagnetischer Strahlung mit einer Reflexionsschicht, die mindestens eine reflektierende Komponente aufweist,
dadurch gekennzeichnet, dass
- für die Reflexionsschicht als reflektierende Komponente eine Substanz oder eine Mischung aus der Gruppe der folgenden Substanzen ausgewählt ist: Kohlenstoffpartikel oder -fasern, insbesondere Ruß und/oder Graphit und/oder eine elektrisch leitende Graphitverbindung, Metallpartikel und/oder -fasern, insbesondere Kupfer-, Aluminium, Stahl-, Titian- und/oder Eisenpartikel- oder -fasern sowie Partikel einer Metalllegierung, dass
- die Reflexionsschicht elektromagnetische Strahlung in einem Bereich von 16 Hz bis 10 GHz, vorzugsweise in einem Bereich von 200 MHz bis 10 GHz, um mehr als 10 dB dämpft, dass
- die Reflexionsschicht wasserdicht und wasserdampfdurchlässig ist; dass
- die Reflexionsschicht witterungsbeständig ist, und dass
- die Reflexionsschicht zum Anbringen eines Potentialausgleichs ausgelegt ist.

Eine Reflexionsschicht aus einer reflektierenden Komponente hat sich als überraschend wirksame Maßnahme zum Abschirmen gegen elektromagnetische Strahlung erwiesen, die die verschiedenen Anforderungen an Beständigkeit, Wasserdichtigkeit und der Möglichkeit, die Reflexionsschicht zu erden erfüllt. Im einfachsten Fall handelt es sich bei der erfindungsgemäßen Reflexionsschicht um eine mikroperforierte Metallschicht, die durch die Perforation wasserdampfdurchlässig ausgebildet ist.

Soweit die Reflexionsschicht aus Metall oder Metallegierungen besteht, wird die Reflexionsschicht sowohl zur Abschirmung gegen sogenanntem Elektrosmog als auch zur Reflexion von Wärmestrahlung eingesetzt, beides Varianten elektromagnetischer Strahlung. Zur elektromagnetischen Strahlung zählen auch UV-Strahlung und sichtbares Licht. Soweit im Zusammenhang mit Reflexionsschichten im Folgenden von elektromagnetischer Strahlung die Rede ist, wird vorausgesetzt, dass mindestens der Wellenlängen-Bereich elektromagnetischer Strahlung gedämpft wird, der Elektrosmog auslöst. Es ist aber keinesfalls ausgeschlossen, dass auch Strahlung weiterer Wellenlängen-Bereiche, insbesondere des Infrarot-Bereichs reflektiert wird.

Vielfache Verwendung wird jedoch eine erfindungsgemäße Reflexionsschicht finden, bei der die reflektierende Komponente und ein Bindemittel kombiniert sind. Eine solche Reflexionsschicht wird wesentlich geprägt durch die Eigenschaften des jeweils verwendeten Bindemittels. Bindemittel, die wasserdicht sind, also bis zu 200 mm Wassersäule - und teilweise darüber - widerstehen, und die gleichzeitig wasserdampfdurchlässig sind, also einen Sd-Wert unter 30 cm aufweisen, sind an sich bekannt.

Es hat sich herausgestellt, dass solche Bindemittel durch Einbetten von reflektierenden Komponenten zum Aufbau einer vielseitig einsetzbaren Reflexionsschicht geeignet sind, die nicht nur zum Abschirmen elektromagnetischer Strahlung geeignet ist, sondern die auch zusätzlich abdichtende und schützende Funktion beim Schutz von z. B. Bauwerken übernehmen kann. Bevorzugt verfügt also die gesamte Reflexionsschicht, insbesondere, wenn sie unter Verwendung des Bindemittels hergestellt ist, über eine diffusionsäquivalente Luftschichtdicke Sd von maximal 30 cm. Damit ist gewährleistet, dass eine wasserdampfdurchlässige und damit für viele Zwecke einsetzbare Reflexionsschicht bereitgestellt wird.

Als Bindemittel steht eine breite Palette von Kunstharz-Verbindungen zur Verfügung. Es können sowohl Ein-Komponenten-Verbindungen als auch Zwei-Komponenten-Verbindungen eingesetzt werden. Typisch ist z. B. der Einsatz von Acrylatharzen oder von Polyurethan-Kunstharzen. Epoxyharze sind zwar grundsätzlich auch denkbar, bieten aber nur eine sehr spröde, wenig flexible Schichtbildung. Die Auswahl des Bindemittels erfolgt in Abstimmung auf die reflektierende Komponente sowie ggf. auf das Trägersubstrat.

Dem Bindemittel können vor, während oder nach dem Zusatz der reflektierenden Komponente weitere Additive beigemischt werden. Dabei kann es sich um Dispergiermittel handeln, die eine gleichmäßige Verteilung der reflektierenden Komponente gewährleisten, es kann sich um Mittel gegen die Versprödung der Reflexionsschicht handeln, die die Alterungsbeständigkeit der erfindungsgemäßen Reflexionsschicht verbessern. Zugesetzt werden können aber auch Stabilisatoren, Weichmacher und ggf. Füllstoffe, die der Reflexionsschicht ein gewünschtes Volumen verleihen.Häufig werden auch Flammhemmer zugesetzt, die die Brandschutz- Eigenschaften des Produkts verbessern.

Die Abschirmung erfolgt in einem weiten Frequenzbereich von 16 Hz bis 10 GHz, vorzugsweise in einem Bereich von 200 MHz bis 10 GHz. Die Dämpfung von mindestens 10 dB wird über den gesamten Frequenzbereich erreicht. Je nach Art der verwendeten reflektierenden Komponente bzw. des verwendeten Bindemittels werden abschnittsweise in verschiedenen Frequenzbereichen auch deutlich höhere Dämpfungswerte erreicht. Entweder über den gesamten Frequenzbereich oder auch nur abschnittsweise wird die elektromagnetische Strahlung um mehr als 10 dB, insbesondere um mindestens 15 dB, vorzugsweise um mehr als 20 dB gedämpft.

Die Wahl einer geeigneten reflektierenden Komponente und/oder das Einbetten in ein Bindemittel gewährleistet eine gute Witterungsbeständigkeit. Eine Witterungsbeständigkeit, bei der die dämpfenden Eigenschaften der Reflexionsschicht nach mindestens einem Monat Freilandbewitterung nahezu unverändert erhalten bleiben, zeigt, dass die erfindungsgemäße Reflexionsschicht unter praxisnahen Bedingungen zuverlässig einsetzbar ist. Die Eigenschaften der erfindungsgemäßen Reflexionsschicht, insbesondere Leitfähigkeit und -damit verbunden- die abschirmende Wirkung- bleiben demnach unter praxisnahen Bedingungen bis zum abschließenden Einbau im wesentlichen erhalten. Die in ein Bindemittel eingebrachte reflektierende Komponente ist dem Einfluss von Kondenswasser und Luftsauerstoff, der preiswerte und gängige aufgedampfte Metallschichten schnell angreift und korrodiert, in der Regel wesentlich weniger ausgesetzt. Dieses Kriterium erweitert die Einsatzmöglichkeiten der erfindungsgemäßen Reflexionsschicht noch einmal, weil dadurch - anders als bei metallbedampften Bahnen - die Schutzwirkung auch dann noch gegeben ist, wenn z. B. beim Eindecken eines Daches die Reflexionsschicht durch eine Unterbrechung der Bautätigkeit einmal für einige Wochen oder Monate der Witterung ausgesetzt ist.

Gleichzeitig wird die reflektierende Komponente trotz des Einbettens in das Bindemittel nicht abgedeckt bzw. versiegelt, so dass ohne weiteres ein Potentialausgleich angelegt werden kann. Die erfindungsgemäße Reflexionsschicht ist damit zu erden und es wird verhindert, dass die - wenn auch nur gering geladene - Reflexionsschicht selbst elektromagnetische Strahlung in den abzuschirmenden Raum abstrahlt. Durch das Anlegen des Potentialausgleichs wird verhindert, dass die Reflexionsschicht elektromagnetische Strahlung absorbiert und dies dann zum abzuschirmenden Raum hin abgibt.

Als reflektierende Komponente können eine einzelne Substanz oder ein Gemisch von Substanzen eingesetzt werden. Diese Einzel- oder Mischkomponente wird vorzugsweise aus der folgenden Gruppe von Substanzen ausgewählt: Kohlenstoffpartikel oder -fasern, insbesondere Ruß und/oder Graphit und/oder elektrisch leitende Graphitverbindungen, Metallpartikel und/ oder -fasern, insbesondere Kupfer-, Aluminium-, Stahl-, Titan-und/ oder Eisenpartikel oder -fasern sowie Partikel von Metalliegierungen. Diese Partikel oder Fasern lassen sich gut in Bindemittel einmischen und gleichmäßig verteilen. Falls erforderlich, kann ein Dispergiermittel zugesetzt werden, um die Verteilung der reflektierenden Komponente zu optimieren.

Insbesondere wenn dem Bindemittel Graphit oder eine elektrisch leitende Graphitverbindung als reflektierende Komponente zugesetzt wird, erweist sich die erfindungsgemäße Reflexionsschicht als langfristig reflektierend. Falls erforderlich, wird der Mischung aus Graphit und/oder einer Graphitverbindung zusätzlich ein Dispergiermittel zugesetzt, um eine gleichmäßige Verteilung der reflektierenden Komponente zu gewährleisten.

Als reflektierende Komponente sind auch korrosionsfeste Metalle, Metalloxide sowie Legierungen von Metallen, aber auch Mischungen von Metallen bzw. Legierungen und/oder Oxiden sehr geeignet. Metalle wie Chrom, Titan, Zink, Eisen und/oder Nickel, Oxide von Metallen wie Aluminiumoxid oder Titanoxide und/oder Siliciumdioxid sind zum Erzeugen einer Reflexionsschicht sehr geeignet.

Je nach Art und Form der reflektierenden Komponente können schon ca. 5 Gewichtsprozent (Gew.-%) Anteil an der Reflexionsschicht genügen, um gegenüber der elektromagnetischen Strahlung die dämpfende Wirkung zu gewährleisten. Mit derart geringen Anteilen von reflektierender Komponente kommt man insbesondere dann aus, wenn z. B. faserförmige Substanzen mit einem hohen Aspektverhältnis (Länge zu Breite) eingesetzt werden, die mit großer Oberfläche zahlreiche Kontaktstellen zu anderen Fasern bieten. Es liegt aber durchaus auch im Rahmen der Erfindung, dass bis zu 20 Gew.-%, 50 Gew.-% oder auch mehr als 75 Gew.-% an reflektierender Komponente in der Reflexionsschicht eingesetzt sind. Entscheidend ist, dass ausreichend reflektierende Komponente zugesetzt wird, um die Reflexionsschicht lückenlos reflektierend zu gestalten. Die erforderliche Menge an reflektierender Substanz kann dann durch einfache Versuche ermittelt werden. Eingesetzt werden entweder unvermischte Substanzen, z. B. ausschließlich Graphit, Aluminium, Kupfer, titan, Eisen oder Stahl, oder Mischungen verschiedener Substanzen, z. B. Graphit und Metallfasern oder Metall mit Metalloxiden oder es können Metalllegierungen eingesetzt werden, ggf. in Verbindung mit Metalloxiden.

Nach einer besonders vorteilhaften Weiterbildung der Erfindung ist die Reflexionsschicht mehrlagig, mindestens zweilagig aufgebaut. Dabei ist mindestens eine Lage der Reflexionsschicht aus einem Bindemittel und einer reflektierenden Komponente aufgebaut. Zur Verbesserung der dämpfenden Wirkung kann eine zweite Lage der Reflexionsschicht angeordnet sein. Beispielsweise hat es sich als vorteilhaft erwiesen, auf die Reflexionsschicht nach Anspruch 1 eine Schicht aus Metall oder aus einer Metalllegierung aufzutragen, insbesondere aufzudampfen. Der Dämpfungsgrad einer solchen Reflexionsschicht erhöht sich sehr. Allerdings ist Voraussetzung für die langfristige Wirkung einer solchen aufgedampften Metall- oder Legierungssschicht, dass diese nicht an freiliegend angebracht ist, weder auf der Außen- noch auf der Innenseite der Reflexionsschicht, da ansonsten der Einfluss von Kondenswasser und Luftsauerstoff -wie aus dem Stand der Technik bekannt- zu einem raschen Abbau der Reflexionsschicht führen.

Es liegt auf der Hand, dass bei der vorbeschriebenen Ausführungsform ohne weiteres noch einmal eine Reflexionsschicht gemäß Anspruch 1 auf die freie Oberfläche der Metallschicht aufgetragen sein kann. Eine solche mehrlagige Reflexionsschicht ist besonders witterungsbeständig und hochdämpfend.

Nach einer erfindungsgemäßen Weiterbildung der Erfindung kann die Reflexionsschicht auf einem Trägermaterial angeordnet sein. Als Trägermaterial können beispielsweise verschiedenste Folien oder Vliese eingesetzt werden. Voraussetzung ist, dass das Trägermaterial wasserdampfdurchlässig ist. Das Trägermaterial kann als einlagiges oder als mehrlagiges Produkt, auch als Kombination aus Folie und Vlies ausgebildet sein. Weiter ist erforderlich, dass das Bindemittel mit der reflektierenden Komponente auf der Oberfläche des Trägersubstrats gut haftet. Dies ist jedoch bei der Mehrzahl der Folien und Vliese der Fall. Besonders bevorzugt werden Trägersubstrate aus Polyester, Polyethylen, Polyacrylat, Glasfaser, Papier, Polyamid, Polyurethan oder Textilfasern oder Mischungen der vorgenannten Faser- und /oder Harztypen.

Die Reflexionsschicht ist - ebenso wie das ggf. eingesetzte Trägermaterial - wasserdampfdurchlässig. Dies wird ermöglicht durch die Ausbildung der Reflexionsschicht aus Bindemittel und reflektierender Komponente, die das Trägersubstrat nicht versiegeln wie eine Metallfolie. Dadurch, dass die erfindungsgemäße Reflexionsschicht wasserdampfdurchlässig ist, erweitern sich die Verwendungsmöglichkeiten sehr, insbesondere kann die Bahn nun auch als Unterspannbahn und als Fassadenbahn zur Isolierung von Dach- oder Wandflächen eingesetzt werden.

Eine besonders vorteilhafte Ausführung der erfindungsgemäßen Reflexionsschicht sieht vor, dass die Reflexionsschicht auf eine geschäumte Schicht eines Trägersubstrats aufgetragen ist. Die geschäumte Schicht ist vorzugsweise offenporig und erfüllt damit die Voraussetzungen der Wasserdichtigkeit und der Wasserdampfdurchlässigkeit. Das Auftragen der Reflexionsschicht auf die geschäumte Schicht ermöglicht einen sparsamen Einsatz von reflektierender Komponente sowie ggf. Bindemittel.

Solche mehrschichtigen Produkte können als Bahnen oder Folien ausgebildet sein, die eine Materialstärke von ca. 80 µm bis ca. 150 µm oder darüber aufweisen. Mehrschichtige Bahnen oder Folien mit Reflexionsschicht sind besonders robust und einfach zu handhaben.

Gegenstand der Erfindung ist schließlich ein Potentialausgleich, der zum Verbinden von zwei erfindungsgemäßen Reflexionsschichten verwendet wird. Der Potentialausgleich ist entweder als Metallband oder als Band aus einem Metallgeflecht, ggf. auf einem Trägermaterial ausgebildet. Alternativ kann der Potentialausgleich als bandförmige Bahn mit den Merkmalen der erfindungsgemäßen Reflexionsschicht ausgebildet sein oder - wie nachstehend beschrieben- als einfacher, leitender Nagel ausgeführt sein.

Ein Potentialausgleich kann auf verschiedene Weise an der Reflexionsschicht angebracht sein. Er kann z. B. mit einem leitfähigen Kleber verklebt sein. Bevorzugt wird jedoch ein mechanisches Anbringen, beispielsweise durch Andrücken, Verhaken oder Verkrallen, bei dem elektrisch leitende Abschnitte des Potentialausgleichs an der Oberfläche oder nach Eindringen in die Reflexionsschicht mit der reflektierenden Komponente in Berührung gebracht sind. Eine besonders bevorzugte Ausführung des Potentialausgleichs sieht vor, dass die erfindungsgemäße Reflexionsschicht im Randbereich ggf. einen erhöhten Anteil der reflektierenden Komponente aufweist, und dann einfach durch Nageln mit leitenden Nägeln (Edelstahl, Kupfer) fixiert ist. Insbesondere wenn die Reflexionsschicht ein Gitter leitender Drähte aufweist, können Nägel dann zum Erden der Reflexionsschicht verwendet werden, wenn der Durchmesser der Nägel größer ist als der Abstand der Drähte zueinander.

Dadurch, dass die erfindungsgemäße Reflexionsschicht zum Anbringen eines Potentialausgleichs ausgelegt ist, besteht die Möglichkeit, eine Feldweiterleitung zu unterbinden. Üblicherweise wird die Reflexionsschicht durch den Potentialausgleich spannungsfrei gestaltet, so dass die Reflexionsschicht selbst nicht nach Art einer Antenne elektromagnetische Strahlung bzw. elektromagnetische Felder an den abzuschirmenden Raum weiterleitet. Diese Möglichkeit ist bei vielen Produkten aus dem Stand der Technik nicht gegeben und schränkt daher die erreichbare Dämpfung sehr ein.

Nach einer bevorzugten Weiterbildung der Erfindung ist die Reflexionsschicht mehrlagig ausgebildet und mindestens eine Lage enthält einen Flammhemmer. Die erfindungsgemäße Reflexionsschicht ist dadurch für breite Verwendungszwecke im Baubereich verwendbar. Sie ist in die Brandschutzklasse B₂ einzureihen. Dies unterscheidet die Reflexionsschicht von einigen Wettbewerbsprodukten, die lediglich die Brandschutzklasse B₃ erreichen.

Gegenstand der Erfindung ist auch ein Verfahren zum Dämpfen elektromagnetischer Strahlung, bei dem eine wasserdichte und wasserdampfdurchlässige Reflexionsschicht zur Reflexion elektromagnetischer Strahlung mindestens ein reflektierende Komponente und ein Bindemittel aufweist, und bei der die Reflexionsschicht zum Anbringen eines Potentialausgleichs ausgelegt ist, in der Weise verlegt wird, dass die Reflexionsschicht der auftreffenden elektromagnetischen Strahlung zugewandt ist, ein Potentialausgleich angelegt wird und ggf. mehrere Reflexionsschichten mit einem Potentialausgleich untereinander verbunden werden.

Auf diese Weise wird gewährleistet, dass die Dämpfungswirkung bzw. die Reflexion der erfindungsgemäßen Reflexionsschicht maximal ausgenutzt wird. Wesentlich bei dem erfindungsgemäßen Verfahren ist das Anlegen des Potentialausgleichs, ggf. das Verbinden von zwei nebeneinander verlegten Reflexionsschichten mittels eines Potentialausgleichs, damit ein Abstrahlen der elektromagnetischen Strahlung von der Reflexionsschicht aus in den abgeschirmten Raum hinein vermieden wird.

Die Reflexionsschicht muss den abzuschirmenden elektromagnetischen Strahlen zugewandt sein, so dass ein Maximum an auftreffernder Strahlung erfasst und abgeschirmt wird. Das heißt jedoch nicht, dass die Reflexionsschicht außenliegend sein muss. Typischerweise als Unterspannbahn im Dachbereich oder als Fassadenbahn verwendet, genügt das übliche Verlegen als Bestandteil der Dachhaut bzw. der Fassade, um die gewünschte Dämpfung zu erreichen. Bei diesen Verwendungen erweist sich die Flexibilität der erfindungsgemäßen Reflexionsschicht als besonders vorteilhaft.

Im Folgenden werden Details der Erfindung an Ausführungsbeispielen näher erläutert.

### 1. Basis: wässrige Dispersionen

Auf ein Polyestervlies (120 g/m²), das als Trägermaterial dient, wird ein flammhemmend ausgerüsteter Acrylatschaum als wasserdampfdurchlässige Basisbeschichtung aufgetragen und in 2 Stufen bei 70 und 170°C getrocknet.
Dieses Vormaterial mit einem Flächengewicht von ca. 200g/m² und einem sd-Wert von 0,02 m dient als Trägermaterial für die leitfähige, abschirmende Schicht (Reflexionsschicht).

### 1.1 Beispiel 1:

Das unter 1 beschriebene Vormaterial wird zunächst mit Aluminium bedampft.

Hierauf wird als zweite Lage eine Mischung aus Graphit und Bindemittel aufgetragen: in eine Polyurethan-Vorkondensat-Mischung, die als Bindemittel dient, wird 20 Gew-% leitfähiger Graphit eingerührt, so dass eine homogene Mischung entsteht.

Diese zweite Lage wird bei einer Temperatur von 70°C vorgetrocknet, hydrophobiert und bei 170°C endgültig getrocknet.

Die so entstandene, flexible, diffusionsoffene und wasserdichte Bahn mit einem Flächengewicht von 230 g/m² ist geeignet zum Einsatz als Unterspannbahn oder Fassadenbahn. Die Dämpfung der auftreffenden elektromagnetischen Wellen und weitere gemessene Eigenschaften sind in Tabelle 1 wiedergegeben.

**Tabelle 1: Eigenschaften der Bahn aus Beispiel 1:**

| | Neuware | Nach 1 Monat Freibewitterung |
|---|---|---|
| Abschirmung im Frequenzbereich 200 MHz bis 10 GHz | > 12 dB | > 12 dB |
| Wasserdampfdurchlässigkeit (EN 12572: 0-85/23°C) | 300 g/m² * d (sd-Wert 0,16 m) | 300 g/m² * d (sd-Wert 0,16 m) |
| Wasserdichtigkeit als Wassersäule (EN 20811) | > 1000 mm | > 1000 mm |
| Brandverhalten (DIN 4102) | B2 | B2 |

### 1.2 Beispiel 2:

In eine Polyurethan-Vorkondensat-Mischung werden 5 Gew.-% Karbonfasern der Länge 3 mm eingearbeitet, so dass eine homogene Mischung entsteht. Diese Mischung wird auf das unter 1. beschriebene Vormaterial aufgetragen, bei einer Temperatur von 70°C vorgetrocknet, hydrophobiert und bei 170°C endgültig getrocknet.

Die so entstandene, flexible, diffusionsoffene und wasserdichte Bahn mit einem Flächengewicht von 230 g/m² ist geeignet zum Einsatz als Unterspannbahn oder Fassadenbahn. Die Dämpfung der auftreffenden elektromagnetischen Wellen und weiteren gemessenen Eigenschaften sind in Tabelle 2 wiedergegeben.

**Tabelle 2: Eigenschaften der Bahn aus Beispiel 2:**

| | Neuware | Nach 1 Monat Freibewitterung |
|---|---|---|
| Abschirmung im Frequenzbereich 200 MHz bis 10GHz | > 10 dB | > 10 dB |
| Wasserdampfdurchlässigkeit (EN 12572: 0-85/23°C) | 400 g/m2*d (sd-Wert 0,10 m) | 400 g/m2*d (sd-Wert 0,10 m) |
| Wasserdichtigkeit als Wassersäule EN 20811 | > 1000 mm | > 1000 mm |
| Brandverhalten (DIN 4102) | B2 | B2 |

### 1.3. Potentialanschluss für Beispiele 1 und 2:

Für den Potentialanschluss wird ein Ableitblech verwendet: dieser besteht aus einem 0,1 mm dünnen Edelstahlblech und einem angenieteten Kabelschuh für den Abschluss eines Erdungskabels.

Die leitfähige Verbindung zwischen den Bahnen wird mittels eines 50 mm breiten leitfähigen Streifen (Aluminium oder Streifen der Bahnen aus Beispiel 1 bzw. 2) erreicht.

Je nach Anwendung können Ableitblech und Verbindungsstreifen angedrückt (z.B. bei Unterspannbahnen) oder mit leitfähigem Kleber aufgeklebt werden.

### 2. Basis Thermoplast:

### Beispiel 3:

Auf ein Polyesternadelvlies (110 g/m2) wird in einem ersten Arbeitsgang eine Thermoplast-Polyurethanschicht (TPU-Schicht) von 35 g/m2 extrudiert. Der zweite Arbeitsgang besteht aus Extrusionsbeschichtung des 1. Arbeitsgangs mit ebenfalls 35 g/m2 (TPU-Schicht) unter Zulauf eines PP/Edelstahl-Drehergewebes 64/32, so dass das Gewebe zwischen den beiden Polyurethanschichten eingebettet wird.

Eigenschaften des PP/Edelstahl-Drehergewebes:
- Kette: 32 Fäden / 10 cm PP
   32 Fäden / 10 cm Edelstahl 0,08 mm Durchmesser
- Schuß: 32 Fäden / 10 cm Edelstahl 0,08 mm Durchmesser

Die so entstandene, flexible, diffusionsoffene und wasserdichte Bahn mit einem Flächengewicht von 270 g/m2 zeigt die Tabelle 3 aufgelisteten Eigenschaften.

**Tabelle 3: Eigenschaften der Bahn aus Beispiel 3:**

| | Neuware | Nach 1 Monat Freibewitterung |
|---|---|---|
| Abschirmung im Frequenzbereich 200 MHz bis 10GHz | > 10 dB | > 10 dB |
| Wasserdampfdurchlässigkeit (EN 12572: 0-85/23°C) | 260 g/m2*d (sd-Wert 0,15 m) | 260 g/m2*d (sd-Wert 0,15 m) |
| Wasserdichtigkeit als Wassersäule EN 20811 | > 1500 mm | > 1500 mm |

### 2.1 Potentialanschluss für Beispiel 3 :

Zwei gelochte Aluminiumstreifen werden auf jeder Seite der Folie beim 2. Arbeitsgang zwischen Drehergewebe und TPU-Schicht eingebettet: die Breite beträgt 30 mm, die Dicke 15 µm; ein Abstand von 50 mm zwischen dem Folienrand und den Aluminiumstreifen wird eingehalten.

Der Anschluss an den Potentialausgleich und die leitfähige Verbindung der Überlappungen wird dann bei der Verlegung sehr einfach durch die Verwendung von Edelstahlnägeln im Bereich der Aluminiumstreifen erreicht.

### Beispiel 4

Eine typische Bahn, die beispielhaft die wesentlichen Merkmale der Erfindung zeigt, zeigt ein Trägervlies aus Polyester mit einer Polyurethanbeschichtung mit einem Flächengewicht von 70 g/m² für die Polyurethanbeschichtung. Auf diesem Verbund wird in an sich bekannter Weise eine Metallschicht aus Chrom-Nickel (20% Chrom/8o% Nikkel) aufgedampft. Die Metallschicht weist eine Stärke von 60 Nanometern auf. Dieses Vlies bewirkt in einem Frequenzbereich von 16 Hz bis 10 GHz eine Dämpfung von mehr als 10 dB. Die IR-Reflexion beträgt 65% im Bereich 2-20 µm Wellenlänge. Der sd-Wert liegt bei 0,3 m.

### Beispiel 5

Auf das Vlies nach Beispiel 1 ist ein atmungsaktiver Film aus Polypropylen, das mit 60% Kreide verstreckt wurde, aufgetragen. Auf diesen atmungsaktiven Film ist wiederum ein zweites Vlies nach Beispiel 1 aufgetragen. Das Gesamt-Flächengewicht dieser Bahn beträgt 160 g/m². Die Bahn wird mit Titan besputtert, die Schichtdicke beträgt 60 Nanometer. Der sd-Wert liegt bei 0,1 m, die beschichtete Bahn ist diffusionsoffen. Die IR-Reflexion wird mit 43% gemessen. Die Abschirmung gegen Elektrosmog ist größer 10 db.

### Beispiel 6

Auf eine Bahn gemäß Beispiel 1 wird eine Legierung aus Aluminium und Magnesium, AlMg3 (25 Teile Aluminium: 75 Teile Magnesium) aufgedampft. Die Schichtdicke beträgt 80 Nanometer. Bei einem sd-Wert von 0,35 m ist die metallbeschichtete Bahn diffusionsoffen. Die Abschirmung gegen Elektrosmog beträgt 15 dB, die IR-Reflexion wird mit 62% gemessen.

## Patentansprüche

1. Elektromagnetische Strahlung dämpfende, wasserdichte und wasserdampfdurchlässige Bahn zur isolierung von Wand- oder Dachflächen mit mindestens einer Reflexionsschicht, mit mindestens einer reflektierenden Komponente,
**dadurch gekennzeichnet, dass**
- für die Reflexionsschicht als reflektierende Komponente eine Substanz oder eine Mischung aus der Gruppe der folgenden Substanzen ausgewählt ist: Kohlenstoffpartikel oder -fasern, insbesondere Ruß und/oder Graphit und/oder eine elektrisch leitende Graphitverbindung, Metallpartikel und/oder -fasern, insbesondere Kupfer-, Aluminium, Stahl, Titan- und/oder Eisenpartikel- oder -fasern sowie Partikel aus Metallegierungen, wobei die reflektierende Komponente derart angeordnet ist, dass die Reflexionsschicht wasserdampfdurchlässig und witterungsbeständig ist und elektromagnetische Strahlung in einem Bereich zwischen 200 MHz bis 10 GHz um mehr als 10 dB dämpft, sowie zum Anbringen eines Patentialausgleichs ausgelegt ist.

2. Bahn nach Anspruch 1, **dadurch gekennzeichnet, dass** die reflektierende Komponente mit einem Bindemittel versehen ist.

3. Bahn nach Anspruch 1, **dadurch gekennzeichnet, dass** die Reflexionsschicht mehrlagig aufgebaut ist, wobei mindestens eine Lage der Reflexionsschicht eine Mischung aus einem Bindemittel und einer reflektierenden Komponente aufweist.

4. Bahn nach Anspruch 3, **dadurch gekennzeichnet, dass** eine Lage der Reflexionsschicht als Metallschicht, insbesondere eine durch Aufdampfen entstandene Metallschicht ausgebildet ist.

5. Bahn nach Anspruch 3, **dadurch gekennzeichnet, dass** die Reflexionsschicht mindestens eine Lage mit einer reflektierenden Komponente aus einem Metall oder eine Metalliegierung und mindestens eine Lage mit einer reflektierenden Komponente aus einem Nichtmetall aufweist.

6. Bahn nach Anspruch 1, **dadurch gekennzeichnet, dass** das Bindemittel ein Ein- oder Zwei-Komponenten-Kunstharz, insbesondere ein Epoxyharz, eine Polyurethanharz-Verbindung und/ oder eine Polyacrylat-Verbindung ist.

7. Bahn nach Anpruch 1, **dadurch gekennzeichnet, dass** das Bindemittel wasserdampfdurchlässig ist.

8. Bahn nach Anspruch 1, **dadurch gekennzeichnet, dass** auftreffende elektromagnetische Strahlung in einem Bereich von 200 MHz bis 10 GHz, mindestens abschnittsweise um mindestens 15 dB, vorzugsweise um mehr als 20 dB gedämpft wird.

9. Bahn nach Anspruch 1, **dadurch gekennzeichnet, dass** die Reflexionsschicht zum mechanischen Anbringen, insbesondere Verhaken eines Potentialausgleichs ausgelegt ist.

10. Bahn nach Anspruch 1, **dadurch gekennzeichnet, dass** die Reflexionsschicht auf ein Trägermaterial aufgebracht ist, insbesondere auf ein Vlies oder eine Folie.

11. Bahn nach Anspruch 1, **dadurch gekennzeichnet, dass** das Trägermaterial aus einem Kunststoff, insbesondere aus Polyester, Polyethylen, Polyacrylat, Glasfaser, Papier, Polyamid, Polyurethan oder Textilfasern oder Mischungen der vorgenannten Faser- und /oder Harztypen hergestellt ist.

12. Bahn nach Anspruch 1, **dadurch gekennzeichnet, dass** die Reflexionsschicht, ggf. auch das Trägermaterial als flexible Bahn ausgebildet ist.

13. Bahn nach Anspruch 1, **dadurch gekennzeichnet, dass** die Reflexionsschicht normal entflammbar ist, also der Brandschutzklasse B₂ zugeordnet wird.

14. Bahn nach Anspruch 1, **dadurch gekennzeichnet, dass** eine geschäumte Schicht, die gegebenenfalls ein flammhemmendes Mittel enthält, auf eine Reflexionsschicht aufgetragen ist.

15. Bahn nach Anspruch i, **dadurch gekennzeichnet, dass** bei einer mehrlagigen Bahn, die eine Reflexionsschicht aufweist, die Reflexionsschicht außenliegend oder innenliegend angeordnet ist.

16. Bahn nach Anspruch 1, **dadurch gekennzeichnet, dass** der Reflexionsschicht Dispergiermittel, Weichmacher und/oder Mittel gegen die Versprödung der Reflexionsschicht, Stabilisatoren und/oder Flammhemmer zugesetzt sind

17. Bahn nach Anspruch 1, **dadurch gekennzeichnet, dass** die Reflexionsschicht nach einer Freilandbewitterung von 1 Monat unverändert die auf die Reflexionsschicht auftreffende elektromagnetische Strahlung in einem Bereich von 200 MHz bis 10 GHz um mehr als 10 dB dämpft.

18. Verfahren zum Dämpfen elektromagnetischer Strahlung, bei dem
- eine wasserdichte und wasserdampfdurchlässige Bahn zur Dämpfung elektromagnetischer Strahlung mindestens eine Reflexionsschicht mit einer reflektierenden Komponente und einen Bindemittel aufweist, und bei der die Reflexionsschicht zum Anbringen eines Potentialausgleichs ausgelegt ist,
- in der Weise verlegt wird, dass die Reflexionsschicht der auftreffenden elektromagnetischen Strahlung zugewandt ist,
- ein Potentialausgleich angelegt wird und ggf, mehrere Reflexionsschichten mit einem Potentialausgleich untereinander verbunden werden.

19. Verfahren nach Anspruch 18, **dadurch gekennzeichnet, dass** als reflektierende Komponenten eine Substanz oder eine Mischung aus der Gruppe der folgenden Substanzen ausgewählt wird: Kohlenstoffpartikel oder-fasern, inshesondere Ruß und/oder Graphit und/oder eine elektrisch leitende Graphitverbindung, Metallpartikel und/oder -fasern,insbesondere Kupfer-, Aluminium, Titan, Stahl- und/oder Eisenpartikel- oder -fasern sowie Partikel einer Metalllegierung.

20. Potentialausgleich zur Verwendung beim Verbinden von zwei Reflexionsschichten nach einem der Ansprüche 1 bis 17, **dadurch gekennzeichnet, dass** der Potentialausgleich als Metallband oder als Band ausgebildet ist, dass die Merkmale der Reflexionsschicht nach mindestens einem der Ansprüche 1 bis 17 aufweist.

## Claims

1. Waterproof and water vapour pervious strip for the attenuation of electromagnetic radiation for the isolation of wall and roof surfaces, including at least one reflective layer, including at least one reflective component, **characterised in that**
- for the reflective layer, serving as reflective component, a substance or a mixture of the group of the following substances is selected: carbon particles or fibres, in particular carbon black and/or graphite and/or an electrically conductive graphite composition, metal particles and/or fibres, in particular copper, aluminium, steel, titanium and/or iron particles or fibres as well as particles of metal alloys, whereby the reflective component is positioned in such a manner that the reflective layer is water vapour pervious and weather-resistant and attenuates electromagnetic radiation in a range between 200 MHz up to 10 GHz by more than 10 dB and is adapted for applying a potential compensation means.

2. Strip according to claim 1, **characterised in that** the reflective component includes a binder.

3. Strip layer according to claim 1, **characterised in that** the reflective layer is of multiple layer structure, wherein at least one layer of the reflective layer includes a mixture of a binder and a reflecting component.

4. Strip according to claim 3, **characterised in that** a layer of the reflective layer takes the form of a metal layer, in particular a metal layer formed by vapour-coating.

5. Strip according to claim 3, **characterised in that** the reflective layer includes at least one layer having a reflective component composed of a metal or metal alloy and at least one layer including a reflective component of a non-metal.

6. Strip according to claim 1, **characterised in that** the binder is a single or dual component resin, in particular an epoxy resin, a polyurethane resin composition and/or a polyacrylate composition.

7. Strip according to claim 1, **characterised in that** the binder is water vapour pervious.

8. Strip according to claim 1, **characterised in that** the incident electromagnetic radiation in a range of 200 MHz up to 10 GHz, is attenuated by more than 15 dB, preferably by more than 20 dB, at least regionally.

9. Strip according to claim 1, **characterised in that** the reflective layer is designed for the mechanical application, in particular by interhooking of a potential compensation means.

10. Strip according to claim 1, **characterised in that** the reflective layer is applied onto a substrate, in particular onto a non-woven web or a foil.

11. Strip according to claim 1, **characterised in that** the substrate material is produced of a plastics, in particular of polyester, polyethylene, polyacrylate, glass fibre, paper, polyamide, polyurethane or textile fibres or mixtures of the aforesaid fibre and/or resin types.

12. Strip according to claim 1, **characterised in that** the reflective layer and where applicable also the substrate is in the form of a flexible strip.

13. Strip according to claim 1, **characterised in that** the reflective layer has normal flame resistance, being classified as fire protective class B2.

14. Strip according to claim 1, **characterised in that** a foamed layer which optionally contains a flame retardant has been applied onto a reflective layer.

15. Strip according to claim 1, **characterised in that** in the case of a multiple layer strip including a reflective layer, the reflective layer is provided on the outside or the inside.

16. Strip according to claim 1, **characterised in that** dispersion agents, softening agents and/or agents counteracting embrittlement of the reflective layer, stabilisers and/or flame retardants have been added to the reflective layer.

17. Strip according to claim 1, **characterised in that** the reflective layer after an exposure of 1 month to the weather attenuates the electromagnetic radiation incident onto the reflective layer in a range of 200 MHz up to 10 GHz unchanged by more than 10 dB.

18. Process for attenuating electromagnetic radiation in which
- a waterproof and water vapour pervious strip for attenuating electromagnetic radiation includes at least one reflective layer with a reflective component and a binder, and in which the reflective layer is adapted for the application of a potential compensation means,
- is applied in such a manner that the reflective layer faces the incident electromagnetic radiation,
- a potential compensation means is fitted and, where applicable, a plurality of reflective layers are interconnected by means of a potential compensation means.

19. Process according to claim 18, **characterised in that** as a reflective component a substance is used or a mixture selected from the group of the following substances: carbon particles or fibres, in particular carbon black and/or graphite and/or an electrically conductive graphite composition, metal particles and/or fibres, in particular copper, aluminium, titanium, steel and/or iron particles or fibres as well as particles of a metal alloy.

20. Potential compensation means for use for connecting two reflective layers according to any one of claims 1 to 17, **characterised in that** the potential compensation means takes the form of a metal strip or as a strip comprising the features of the reflective layer according to at least one of claims 1 to 17.

## Revendications

1. Lé amortissant le rayonnement électromagnétique, étanche à l'eau et perméable à la vapeur d'eau pour l'isolation de surfaces de murs ou de toits avec au moins une couche réfléchissante, avec au moins une composante réfléchissante,
**caractérisé en ce que**
- l'on sélectionne pour la couche réfléchissante comme composante réfléchissante, une substance ou un mélange du groupe de substances suivantes : particules ou fibres de carbone, en particulier suie et/ou graphite et/ou une composition de graphite électroconductrice, particules et/ou fibres de métal, en particulier particules ou fibres de cuivre, aluminium, acier, titane et/ou fer ainsi que particules d'alliages de métal, la composante réfléchissante étant placée de telle manière que la couche réfléchissante est perméable à la vapeur d'eau et est résistante aux intempéries et qu'elle amortit de plus de 10 dB le rayonnement électromagnétique dans une plage entre 200 MHz et 10 GHz et qu'elle est également conçue pour appliquer une compensation de potentiel.

2. Lé selon la revendication 1, **caractérisé en ce que** la composante réfléchissante est pourvue d'un liant.

3. Lé selon la revendication 1, **caractérisé en ce que** la couche réfléchissante est construite en plusieurs couches, au moins une couche de la couche réfléchissante présentant un mélange constitué par un liant et une composante réfléchissante.

4. Lé selon la revendication 3, **caractérisé en ce qu'**une couche de la couche réfléchissante est configurée comme une couche métallique, en particulier comme une couche métallique créée par métallisation sous vide.

5. Lé selon la revendication 3, **caractérisé en ce que** la couche réfléchissante présente au moins une couche avec une composante réfléchissante en un métal ou un alliage de métal et au moins une couche avec une composante réfléchissante constituée par un non-métal.

6. Lé selon la revendication 1, **caractérisé en ce que** le liant est une résine synthétique à un ou deux composants, en particulier une résine époxy, une liaison avec résine au polyuréthane et/ou une liaison au polyacrylate.

7. Lé selon la revendication 1, **caractérisé en ce que** le liant est perméable à la vapeur d'eau.

8. Lé selon la revendication 1, **caractérisé en ce que** le rayonnement électromagnétique incident est amorti dans une plage de 200 MHz à 10 GHz au moins par section d'au moins 15 dB, de préférence de plus de 20 dB.

9. Lé selon la revendication 1, **caractérisé en ce que** la couche réfléchissante est conçue pour l'application mécanique, en particulier pour l'accrochage d'une compensation de potentiel.

10. Lé selon la revendication 1, **caractérisé en ce que** la couche réfléchissante est appliquée sur un matériau de support, en particulier sur un non-tissé ou une feuille.

11. Lé selon la revendication 1, **caractérisé en ce que** le matériau de support est fabriqué dans une matière synthétique, en particulier en polyester, polyéthylène, polyacrylate, fibre de verre, papier, polyamide, polyuréthane ou en fibres textiles ou en mélanges des types de fibres et/ou de résine mentionnés ci-dessus.

12. Lé selon la revendication 1, **caractérisé en ce que** la couche réfléchissante, éventuellement aussi le matériau de support, est configurée comme un lé flexible.

13. Lé selon la revendication 1, **caractérisé en ce que** la couche réfléchissante est normalement inflammable, est donc classée en classe de feu B2.

14. Lé selon la revendication 1, **caractérisé en ce qu'**une couche expansée, qui contient éventuellement une substance ignifuge, est appliquée sur une couche réfléchissante.

15. Lé selon la revendication 1, **caractérisé en ce que**, pour un lé en plusieurs couches qui présente une couche réfléchissante, la couche réfléchissante est placée à l'extérieur ou à l'intérieur.

16. Lé selon la revendication 1, **caractérisé en ce que** des agents dispersants, des plastifiants et/ou des substances contre la fragilité de la couche réfléchissante, des stabilisants et/ou des substances ignifuges sont ajoutées à la couche réfléchissante.

17. Lé selon la revendication 1, **caractérisé en ce que** la couche réfléchissante amortit de façon inaltérée, après une exposition aux intempéries naturelles d'un mois, le rayonnement électromagnétique incident sur la couche réfléchissante dans une gamme de 200 MHz à 10 GHz de plus de 10 dB.

18. Procédé pour amortir le rayonnement électromagnétique pour lequel
- un lé étanche à l'eau et perméable à la vapeur d'eau présente, pour l'amortissement du rayonnement électromagnétique, au moins une couche réfléchissante avec une composante réfléchissante et un liant, et pour laquelle la couche réfléchissante est conçue pour appliquer une compensation de potentiel,
- est posé de manière que la couche réfléchissante est tournée vers le rayonnement électromagnétique incident,
- qu'il est appliqué une compensation de potentiel et qu'éventuellement plusieurs couches réfléchissantes sont liées l'une à l'autre avec une compensation de potentiel.

19. Procédé selon la revendication 18, **caractérisé en ce que** comme composant réfléchissant on choisit une substance ou un mélange sélectionné dans le groupe des substances suivantes : particules ou fibres de carbone, en particulier suie et/ou graphite et/ou une composition de graphite électroconductrice, des particules et/ou fibres de métal, en particulier des particules ou fibres de cuivre, aluminium, titane, acier et/ou fer ainsi que des particules d'un alliage de métal.

20. Compensation de potentiel à utiliser lors de la liaison de deux couches réfléchissantes selon l'une des revendications 1 à 17, **caractérisée en ce que** la compensation de potentiel est configurée comme une bande de métal ou comme une bande qui présente les caractéristiques de la couche réfléchissante selon au moins l'une des revendications 1 à 17.
